# EUROPÄISCHE PATENTSCHRIFT

(11) **EP 3 188 924 B1**
(45) Veröffentlichungstag und Bekanntmachung des Hinweises auf die Patenterteilung: **20.11.2019**
(21) Anmeldenummer: 15763244.9
(22) Anmeldetag: 01.09.2015
(51) Int. Cl.: B60L 3/00

(54) **VERFAHREN UND VORRICHTUNG ZUR ÜBERWACHUNG EINES ELEKTRISCHEN NETZWERKS IN EINEM SCHIENENFAHRZEUG SOWIE SCHIENENFAHRZEUG**
METHOD AND DEVICE FOR MONITORING AN ELECTRIC NETWORK IN A RAIL VEHICLE AND RAIL VEHICLE
PROCÉDÉ ET DISPOSITIF DE SURVEILLANCE D'UN RÉSEAU ÉLECTRIQUE DANS UN VÉHICULE FERROVIAIRE ET VÉHICULE FERROVIAIRE

(30) Priorität: 01.09.2014 DE 102014217431
(43) Veröffentlichungstag der Anmeldung: 12.07.2017
(73) Patentinhaber: Bombardier Transportation GmbH, 10785 Berlin (DE)
(72) Erfinder: STREIFF, Fabian, CH-8304 Wallisellen (CH); ISEPPONI, Gerhard, CH-8113 Boppelsen (CH)
(74) Vertreter: Ramrath, Lukas
(86) Internationale Anmeldenummer: PCT/EP2015/069885
(87) Internationale Veröffentlichungsnummer: WO 2016/034548

(56) Entgegenhaltungen:
- DE-A1-102010 063 374
- DE-A1-102012 223 895
- JP-A- 2013 192 300

## Beschreibung

In Schienenfahrzeugen werden u.a. sogenannte Permanentmagnetmaschinen, die auch als Permanentmagnet-Motoren bezeichnet werden können, zum Antrieb des Schienenfahrzeugs eingesetzt. Diese werden über ein in der Regel dreiphasiges elektrisches Netzwerk mit elektrischer Energie versorgt. Das elektrische Netzwerk umfasst hierbei auch einen Stromrichter, der in einem motorischen Betrieb der Permanentmagnetmaschine eine Gleichspannung, beispielsweise eine Zwischenkreisspannung, in eine gewünschte Wechselspannung zum Versorgen der Permanentmagnetmaschine umwandelt. Der Stromrichter kann in einem generatorischen Betrieb der Permanentmagnetmaschine jedoch auch die von der Permanentmagnetmaschine erzeugte Wechselspannung in eine Gleichspannung umwandeln.

In dem elektrischen Netzwerk können ungewünschte Kurzschlüsse auftreten. Diese können sowohl innerhalb der Permanentmagnetmaschine, z.B. innerhalb eines Gehäuses der Maschine, oder entlang einer Phasenleitung zur Verbindung des Stromrichters und der Permanentmagnetmaschine auftreten. Auch können Kurzschlüsse im Stromrichter auftreten. Bei Kurzschlüssen können auch sogenannte Lichtbögen auftreten, die zu einer ungewünschten Zerstörung von Bauteilen des Schienenfahrzeuges führen können.

Es ist bekannt, eine Höhe eines Phasenstroms zu überwachen, wobei ein Kurzschluss detektiert wird, wenn die Höhe des Phasenstroms über einem vorbestimmten Schwellwert liegt.

Wird ein solcher Kurzschluss detektiert, so wird in der Regel der Stromrichter von der Permanentmagnetmaschine elektrisch abgetrennt, beispielsweise durch entsprechend angeordnete Leistungsschalter. Gleichzeitig wird das Schienenfahrzeug bis zum Stillstand abgebremst, um eine potentielle Speisung des Kurzschlusses zu verhindern.

Die JP 2013 192300 A offenbart eine Permanentmagnetmotor-Antriebsvorrichtung, die umfasst: einen Dreiphasen-Permanentmagnetmotor zum Antreiben eines Fahrzeugs; einen Inverter, um den Permanentmagnetmotor anzutreiben; Motorschütze in jeder Leitung der drei Phasenverbindungen des Umrichters mit dem Permanentmagnetmotor und zum Durchführen einer elektrischen Verbindung / Trennung; einen Spannungsdetektor, der mit den Drähten und zum Erfassen Klemmenspannung des Permanentmagnetmotor verbunden ist; und eine Steuereinrichtung für die Herstellung der Trennung durch Öffnung der Motorschütze, wenn die Vorrichtung fehlerhaft ist. Eine Motorschütz-Öffnung ist zwischen dem Spannungsdetektor und dem Permanentmagnetmotor in den Drähten vorgesehen.

Die DE 10 2010 063 347 A1 offenbart ein Verfahren zum Einstellen der von einer Feststellbremse ausgeübten Klemmkraft in einem Fahrzeug.

Es stellt sich das technische Problem, ein Verfahren und eine Vorrichtung zur Überwachung eines elektrischen Netzwerkes in einem Schienenfahrzeug sowie ein Schienenfahrzeug zu schaffen, die eine Überwachung des Netzwerks auch im abgetrennten Zustand der elektrischen Maschine ermöglichen.

Die Lösung des technischen Problems ergibt sich durch die Gegenstände mit den Merkmalen der Ansprüche 1, 8 und 10. Weitere vorteilhafte Ausgestaltungen der Erfindung ergeben sich aus den Unteransprüchen.

Vorgeschlagen wird ein Verfahren zur Überwachung eines elektrischen Netzwerks in einem Schienenfahrzeug. Das elektrische Netzwerk kann insbesondere ein Traktionsnetz des Schienenfahrzeugs sein oder einen Teil des Traktionsnetzes des Schienenfahrzeugs bezeichnen. Das elektrische Netzwerk dient insbesondere einer Energieübertragung zwischen einem Stromrichter des Schienenfahrzeugs und einer Permanentmagnetmaschine des Schienenfahrzeugs.

Das elektrische Netzwerk umfasst mindestens einen Stromrichter. Der Stromrichter kann hierbei sowohl als Wechselrichter als auch als Gleichrichter betrieben werden. Beispielsweise kann der Stromrichter als dreiphasiger Stromrichter ausgebildet sein. Der Stromrichter kann insbesondere elektrische Schaltelemente wie z.B. MOSFET oder IGBT umfassen.

Der Stromrichter kann eingangsseitig mit einem Zwischenkreis, insbesondere einem Zwischenkreiskondensator, des Schienenfahrzeugs elektrisch verbunden sein. Eine über dem Zwischenkreiskondensator abfallende Zwischenkreisspannung, die somit eingangsseitig an dem Stromrichter anliegt, ist eine Gleichspannung. Ausgangsseitig kann der Stromrichter mit der Permanentmagnetmaschine verbunden sein, beispielsweise über mindestens eine Phasenleitung.

Weiter umfasst das elektrische Netzwerk die mindestens eine Permanentmagnetmaschine. Die Permanentmagnetmaschine bezeichnet hierbei eine Synchronmaschine mit einem permanent magnetisierten Rotor. Die Permanentmagnetmaschine kann in einem motorischen Betrieb betrieben werden. Hierbei wird elektrische Energie, die vom Stromrichter an die Permanentmagnetmaschine übertragen wird, in mechanische Energie umgewandelt. Die elektrische Energie wird hierbei in Form eines Wechselstroms und einer Wechselspannung übertragen, die die Permanentmagnetmaschine speisen. In einem generatorischen Betriebsmodus wird mechanische Energie durch die Permanentmagnetmaschine in elektrische Energie umgewandelt, wobei die elektrische Energie an den Stromrichter übertragen werden kann. Hierbei erzeugt die Permanentmagnetmaschine einen Wechselstrom und eine Wechselspannung.

Weiter umfasst das elektrische Netzwerk mindestens eine erste Phasenleitung zur elektrischen Verbindung des mindestens einen Stromrichters und der mindestens einen Permanentmagnetmaschine. Die erste Phasenleitung bezeichnet hierbei eine elektrische Leitung, durch die ein erster Phasenstrom fließen kann. Das elektrische Netzwerk umfaßt drei Phasenleitungen. Entlang der Phasenleitung kann mindestens ein elektrisches Schaltelement, beispielsweise ein Leistungsschaltelement, insbesondere ein MOSFET, ein IGBT oder ein Leistungsschalter angeordnet sein. Mittels des elektrischen Schaltelements der ersten Phasenleitung kann eine elektrische Verbindung des Stromrichters und der Permanentmagnetmaschine über die erste Phasenleitung unterbrochen oder hergestellt werden.

Bevorzugt ist der Stromrichter ein dreiphasiger Stromrichter, der über drei Phasenleitungen mit einer dreiphasigen Permanentmagnetmaschine verbunden ist. Weiter wird die erste Phasenleitung unterbrochen. Hierzu kann, wie nachfolgend noch näher erläutert, eine entsprechende Unterbrechungseinrichtung betätigt werden. Vorzugsweise ist die Unterbrechungseinrichtung als elektrisches Schaltelement ausgebildet. Das elektrische Schaltelement kann entlang der ersten Phasenleitung oder in der ersten Phasenleitung angeordnet sein. Mittels des elektrischen Schaltelements kann eine Verbindung des Stromrichters und der Permanentmagnetmaschine über die erste Phasenleitung hergestellt oder unterbrochen werden. Beispielsweise kann die erste Phasenleitung unterbrochen werden, indem das elektrische Schaltelement geöffnet wird. Weiter wird eine Potentialdifferenz zwischen einem maschinenseitigen Teil der Phasenleitung und einem Bezugspotential bestimmt. Das Bezugspotential kann beispielsweise ein Referenzpotential sein, beispielsweise ein Massepotential des elektrischen Netzwerks. Alternativ kann das Bezugspotential das Potential einer weiteren Phasenleitung des elektrischen Netzwerks sein, insbesondere von einem maschinenseitigen Teil dieser weiteren Phasenleitung.

Der maschinenseitige Teil der Phasenleitung bezeichnet hierbei einen Teil oder Abschnitt der Phasenleitung, der einen Bestimmungspunkt der Potentialdifferenz mit der Permanentmagnetmaschine verbindet. Der Bestimmungspunkt bezeichnet wiederum einen Punkt, an oder in dem die Potentialdifferenz bestimmt wird. Der Bestimmungspunkt kann beispielsweise gleich dem Unterbrechungspunkt sein. Der Begriff "Punkt" kann hierbei selbstverständlich auch einen Teilabschnitt der Phasenleitung bezeichnen.

Die Bestimmung der Potentialdifferenz umfasst hierbei das direkte Erfassen der Potentialdifferenz, beispielsweise mittels einer geeigneten Erfassungseinrichtung, insbesondere mittels eines Spannungssensors. Allerdings kann der Begriff "Bestimmen" auch die Berechnung der Potentialdifferenz in Abhängigkeit mindestens einer direkt erfassten Zwischengröße umfassen.

Weiter wird eine potentialdifferenzabhängige Größe bestimmt. Die potentialdifferenzabhängige Größe bildet hierbei einen Indikator für eine Höhe der Potentialdifferenz. Beispielhafte potentialdifferenzabhängige Größen werden nachfolgend noch näher erläutert.

Weiter wird eine Drehzahl der Permanentmagnetmaschine bestimmt. Die Drehzahl kann hierbei direkt erfasst werden, beispielsweise mittels einer geeigneten Erfassungseinrichtung, insbesondere einem Drehzahlsensor. Allerdings ist es auch möglich, die Drehzahl rechnerisch in Abhängigkeit mindestens einer direkt erfassten Größe, beispielsweise einer Fahrgeschwindigkeit des Schienenfahrzeugs, zu bestimmen. Selbstverständlich können hierfür noch weitere, insbesondere vorbekannte, Parameter des Schienenfahrzeugs, beispielsweise Übersetzungsverhältnisse einer mechanischen Verbindung der Permanentmagnetmaschine und drehbaren Rädern des Schienenfahrzeugs, berücksichtigt werden.

Weiter wird in Abhängigkeit der Drehzahl eine drehzahlabhängige Referenzgröße bestimmt, die auch als drehzahlabhängige Größe bezeichnet werden kann. Hierbei kann ein Zusammenhang, beispielsweise ein funktioneller Zusammenhang, zwischen der Drehzahl und der drehzahlabhängigen Größe vorbekannt sein. Die drehzahlabhängige Größe bezeichnet hierbei eine zu der potentialdifferenzabhängigen Größe korrespondierende Größe. Insbesondere kann die drehzahlabhängige Referenzgröße einen Indikator für eine Höhe einer Leerlaufspannung der Permanentmagnetmaschine bei einer bestimmten Drehzahl bilden.

Beispielsweise kann angenommen werden, dass ein linearer Zusammenhang zwischen der Drehzahl und der Höhe der Leerlaufspannung besteht, wobei die Leerlaufspannung mit steigender Drehzahl ansteigt.

Weiter wird eine Abweichung der potentialdifferenzabhängigen Größe von der drehzahlabhängigen Referenzgröße bestimmt. Insbesondere kann eine Differenz zwischen der drehzahlabhängigen Referenzgröße und der potentialdifferenzabhängigen Größe bestimmt werden.

Weiter wird ein Netzwerkfehler detektiert, falls die Abweichung größer als ein vorbestimmter Schwellwert ist. Insbesondere kann also ein Netzwerkfehler detektiert werden, falls die vorhergehend erläuterte Differenz oder ein Betrag der Differenz größer als der vorbestimmte Schwellwert ist. Der vorbestimmte Schwellwert kann hierbei Null betragen oder um ein vorbestimmtes geringes Maß größer als Null sein.

Hierdurch kann in vorteilhafter Weise ein Netzwerkfehler in einem maschinenseitigen Teilnetzwerk, insbesondere in der Permanentmagnetmaschine, detektiert werden, wenn die Permanentmagnetmaschine vom Stromrichter elektrisch getrennt ist. Das maschinenseitige Teilnetzwerk bezeichnet hierbei zumindest den Teil des elektrischen Netzwerks, der zwischen einem Bestimmungspunkt des elektrischen Netzwerks und der Permanentmagnetmaschine angeordnet ist, wobei auch die Permanentmagnetmaschine selbst Teil des maschinenseitigen Teilnetzwerks ist. Somit kann das maschinenseitige Teilnetzwerk zumindest den Abschnitt der ersten Phasenleitung, der den vorhergehend erläuterten Bestimmungspunkt mit der Permanentmagnetmaschine verbindet sowie zumindest einen Teil des elektrischen Netzwerkes der Permanentmagnetmaschine umfassen.

Weiter kann in Abhängigkeit der Höhe der Abweichung, beispielsweise der Höhe der vorhergehend erläuterten Differenz, eine Fehlerart bestimmt werden. Liegt z.B. eine Potentialdifferenz von Null oder nahe Null vor und somit eine hohe, insbesondere maximale, Abweichung der potentialdifferenzabhängigen Größe von der drehzahlabhängigen Referenzgröße, so kann ein Kurzschluss detektiert werden. Ist jedoch die bestimmte Potentialdifferenz ungleich Null, jedoch kleiner als die erwartete Leerlaufspannung, liegt somit zwar eine Abweichung, jedoch keine maximale Abweichung, der potentialdifferenzabhängigen Größe von der drehzahlabhängigen Referenzgröße vor. In diesem Fall kann beispielsweise eine unerwünschte niederimpedante Verbindung, detektiert werden.

Beispielsweise kann eine Fehlerart einem vorbestimmten Abweichungsintervall zugeordnet werden. Liegt die erfindungsgemäß bestimmte Abweichung in einem der fehlerabhängigen Abweichungsintervalle, so kann als Fehlerart derjenige Fehler detektiert werden, der dem entsprechenden fehlerabhängigen Abweichungsintervall zugeordnet ist.

Das erfindungsgemäße Verfahren kann insbesondere nur dann durchgeführt werden, wenn die erste Phasenleitung unterbrochen wird. Dies kann beispielsweise der Fall sein, wenn aufgrund eines weiteren Netzwerkfehlers, insbesondere eines Netzwerkfehlers im Stromrichter, die Phasenleitung bereits unterbrochen ist. Auch kann eine Unterbrechung vorliegen, wenn ein gewünschter Nichtbetrieb des Motors, beispielsweise zur Einsparung von Energie, vorliegt, wobei in diesem Fall ebenfalls die erste Phasenleitung unterbrochen sein kann. Bei einem Nichtbetrieb der Permanentmagnetmaschine kann beispielsweise eine weitere Permanentmagnetmaschine des Schienenfahrzeugs den Antrieb übernehmen.

Weiter umfasst das elektrische Netzwerk drei Phasenleitungen. Weiter werden mindestens zwei, insbesondere zwei der drei, oder alle Phasenleitungen unterbrochen sowie für jede Phasenleitung eine Potentialdifferenz zwischen einem maschinenseitigen Teil der Phasenleitung und einem Bezugspotential bestimmt. Weiter wird jeweils eine potentialdifferenzabhängige Größe bestimmt.

Hierbei kann für jede Phasenleitung eine Potentialdifferenz zwischen der Phasenleitung und einem gemeinsamen Referenzpotential, beispielsweise einem Massepotential des elektrischen Netzwerks bestimmt werden. Alternativ und bevorzugt bildet jedoch für jede Phasenleitung das Potential einer der verbleibenden Phasenleitungen das Bezugspotential. Dies ermöglicht, wie nachfolgend noch näher erläutert, dass z.B. nur zwei Spannungssensoren verwendet werden können, um für drei Phasenleitungen jeweils eine Potentialdifferenz zu bestimmen. Hierbei können die Spannungssensoren jeweils eine Potentialdifferenz zwischen Phasenleitungen eines Leitungspaares erfassen, wobei sich Leitungspaare in jeweils mindestens einer Leitung der beiden Leitungen des Leitungspaares unterscheiden.

Weiter wird, wie vorhergehend erläutert, eine Drehzahl der Permanentmagnetmaschine und in Abhängigkeit der Drehzahl eine drehzahlabhängige Referenzgröße für jede Phasenleitung bestimmt.

In einer ersten Alternative wird für jede Phasenleitung eine Abweichung der potentialdifferenzabhängigen Größe von der drehzahlabhängigen Referenzgröße bestimmt und ein Netzwerkfehler detektiert, falls mindestens eine der Abweichungen größer als ein vorbestimmter Schwellwert ist.

Alternativ oder kumulativ wird eine minimale Potentialdifferenz aller Potentialdifferenzen und eine von dieser minimalen Potentialdifferenz abhängige Größe bestimmt. Die von der minimalen Potentialdifferenz abhängige Größe wird hierbei wie die vorhergehend erläuterte potentialdifferenzabhängige Größe bestimmt. Weiter wird eine Abweichung der von dieser minimalen Potentialdifferenz abhängigen Größe von der drehzahlabhängigen Referenzgröße bestimmt und ein Netzwerkfehler detektiert, falls diese Abweichung größer als ein vorbestimmter Schwellwert ist.

Hierdurch ergibt sich in vorteilhafter Weise, dass auch in einem dreiphasigen elektrischen Netzwerk ein Netzwerkfehler bestimmt werden kann.

Weiter wird in Abhängigkeit der Potentialdifferenzen und/oder der mindestens einen Abweichung ein zweiphasiger Netzwerkfehler oder ein dreiphasiger Netzwerkfehler bestimmt.

Ist mindestens eine der Abweichungen größer als der vorbestimmte Schwellwert und weicht mindestens eine der Potentialdifferenz von den verbleibenden Potentialdifferenzen um mehr als ein vorbestimmtes Maß ab, so kann ein zweiphasiger Netzwerkfehler detektiert werden. Ein solcher zweiphasiger Netzwerkfehler kann beispielsweise ein Kurzschluss zwischen zwei Phasen sein. Ein solcher zweiphasiger Netzwerkfehler kann auch detektiert werden, falls mindestens eine Abweichung größer als der vorbestimmte Schwellwert ist, eine weitere Abweichung jedoch kleiner als oder gleich dem vorbestimmten Schwellwert ist.

Ein dreiphasiger Netzwerkfehler, beispielsweise ein Kurzschluss zwischen allen Phasen, kann detektiert werden, falls mindestens eine Abweichung größer als der vorbestimmte Schwellwert ist und alle Potentialdifferenzen gleich sind. Auch kann ein dreiphasiger Netzwerkfehler detektiert werden, falls alle Abweichungen größer als der vorbestimmte Schwellwert sind.

Hierdurch kann in vorteilhafter Weise eine Art des Netzwerkfehlers bestimmt werden.

In einer weiteren Ausführungsform wird bei Detektion eines Netzwerkfehlers eine Drehzahl der Permanentmagnetmaschine reduziert. Hierfür kann beispielsweise ein Läufer der Permanentmagnetmaschine gebremst werden. Vorzugsweise kann jedoch das Schienenfahrzeug mittels mindestens einer Bremseinrichtung gebremst werden. Selbstverständlich kann die Drehzahl der Permanentmagnetmaschine auf Null reduziert werden. Durch die Reduktion der Drehzahl ergibt sich in vorteilhafter Weise, dass ein Kurzschluss nicht weiter durch die Permanentmagnetmaschine gespeist wird. Hierdurch kann die Gefahr einer unerwünschten Beschädigung reduziert werden.

Alternativ oder kumulativ kann eine weitere Unterbrechung des maschinenseitigen Teils der Phasenleitung durchgeführt werden. Insbesondere kann die elektrische Verbindung zwischen der Phasenleitung und einem Anschlusspunkt der Permanentmagnetmaschine, insbesondere in dem Anschlusspunkt der Permanentmagnetmaschine, unterbrochen werden. Es ist auch vorstellbar, dass die Phasenleitung ein weiteres elektrisches Schaltelement umfasst, welches im maschinenseitigen Teil der Phasenleitung angeordnet ist. Die weitere Unterbrechung kann hierbei durch Öffnen des weiteren elektrischen Schaltelements erfolgen.

Durch eine weitere Unterbrechung des maschinenseitigen Teils der Phasenleitung kann ein Fehlerort elektrisch isoliert werden, der im maschinenseitigen Teil der Phasenleitung liegt.

Vorzugsweise wird eine möglichst motornahe Unterbrechung des maschinenseitigen Teils der Phasenleitung durchgeführt. Insbesondere kann eine Distanz eines Unterbrechungspunktes zum Anschlusspunkt der Phasenleitung an die Permanentmagnetmaschine kleiner als eine vorbestimmte Distanz sein.

In einer weiteren Ausführungsform wird eine Genauigkeit der Bestimmung der Potentialdifferenz überprüft. Wird, wie nachfolgend noch näher erläutert, eine Bestimmungseinrichtung zur Bestimmung der Potentialdifferenz verwendet, so kann hierdurch eine Funktionsfähigkeit dieser Bestimmungseinrichtung überprüft werden. Die Genauigkeit der Bestimmung der Potentialdifferenz wird überprüft, indem bei einer ununterbrochenen Phasenleitung mindestens eine Normalbetriebs-Potentialdifferenz bestimmt wird und eine Abweichung der Normalbetriebs-Potentialdifferenz von einem Normalbetriebs-Referenzwert bestimmt wird. Eine ausreichende Genauigkeit wird detektiert, falls die Abweichung kleiner als ein oder gleich einem vorbestimmten Schwellwert ist. Eine Abweichung der Normalbetriebs-Potentialdifferenz von einem Normalbetriebs-Referenzwert kann insbesondere auch bestimmt werden, indem in Abhängigkeit der Normalbetriebs-Potentialdifferenz eine potentialdifferenzabhängige Größe und in Abhängigkeit des Normalbetriebs-Referenzwerts eine korrespondierende Referenzgröße bestimmt wird, wobei eine Abweichung der potentialdifferenzabhängigen Größe von der korrespondierenden Referenzgröße bestimmt wird.

Der Normalbetriebs-Referenzwert kann beispielsweise gleich einer Zwischenkreisspannung sein. Insbesondere entspricht die Normalbetriebs-Potentialdifferenz einer unter normalen Betriebsbedingungen zu erwartenden Potentialdifferenz, die beispielsweise rechnerisch bestimmt werden kann. Die Genauigkeit der Bestimmung der Potentialdifferenz kann beispielsweise in Abhängigkeit aktueller Betriebsparameter des elektrischen Netzwerkes bestimmt werden. Hierbei kann in Abhängigkeit der aktuellen Betriebsparameter, beispielsweise in Abhängigkeit von Schaltzuständen der Schaltelemente des Stromrichters, die Normalbetriebs-Potentialdifferenz bestimmt werden.

Hierbei wird davon ausgegangen, dass die Genauigkeit der Bestimmung der Potentialdifferenz bei einer unterbrochenen Phasenleitung dann gegeben ist, wenn bei einer ununterbrochenen Phasenleitung eine korrekte Bestimmung erfolgt.

Alternativ oder kumulativ kann die Genauigkeit der Bestimmung der Potentialdifferenz überprüft werden, indem ein Stillstand der Permanentmagnetmaschine detektiert wird, wobei bei einer unterbrochenen Phasenleitung mindestens eine Stillstands-Potentialdifferenz erfasst wird, wobei eine Abweichung der Stillstands-Potentialdifferenz von einem Stillstands-Referenzwert bestimmt wird, wobei eine ausreichende Genauigkeit detektiert wird, falls die Abweichung kleiner als ein oder gleich einem vorbestimmten Schwellwert ist. Eine Abweichung der Stillstands-Potentialdifferenz von einem Stillstands-Referenzwert kann insbesondere auch bestimmt werden, indem in Abhängigkeit der Stillstands-Potentialdifferenz eine potentialdifferenzabhängige Größe und in Abhängigkeit des Stillstands-Referenzwerts eine korrespondierende Referenzgröße bestimmt wird, wobei eine Abweichung der potentialdifferenzabhängigen Größe von der korrespondierenden Referenzgröße bestimmt wird.

Generell ist es möglich, dass ein die Potentialdifferenz oder ein die potentialdifferenzabhängige Größe repräsentierendes oder kodierendes Ausgangssignal umgekehrt proportional zu einer Höhe der Potentialdifferenz oder der potentialdifferenzabhängigen Größe ist. Dies bedeutet, dass ein hoher Signalpegel bzw. ein hohes Ausgangssignals erzeugt wird, falls eine niedrige Potentialdifferenz bestimmt wird. Im Stillstand der Permanentmagnetmaschine weist die zu erwartende Potentialdifferenz erwartungsgemäß einen niedrigen Wert, theoretisch einen Wert von null, auf. Somit kann ein hohes Ausgangssignal erwartet werden. Aufgrund von Fehlern in einer Bestimmungseinrichtung kann jedoch im Stillstand ein niedrigeres Ausgangssignal als das erwartete Ausgangssignal erzeugt werden. Somit können in vorteilhafter Weise Fehler der Bestimmungseinrichtung, beispielsweise Elektronikfehler, detektiert werden.

In einer weiteren Ausführungsform wird die Drehzahl einem Drehzahlintervall von mehreren Drehzahlintervallen zugewiesen, wobei einem Drehzahlintervall eine intervallabhängige Referenzgröße zugewiesen ist, wobei die drehzahlabhängige Referenzgröße als die intervallabhängige Referenzgröße bestimmt wird.

Hierdurch ergibt sich in vorteilhafter Weise ein rechentechnisch einfach durchzuführendes Verfahren.

In einer weiteren Ausführungsform wird die Potentialdifferenz einem Potentialdifferenzintervall von mehreren Potentialdifferenzintervallen zugewiesen, wobei einem Potentialdifferenzintervall ein intervallabhängiger Potentialdifferenzwert zugewiesen ist. Der intervallabhängige Potentialdifferenzwert kann beispielsweise ein minimaler oder ein maximaler Wert des Potentialdifferenzintervalls sein. Weiter wird die potentialdifferenzabhängige Größe in Abhängigkeit des intervallabhängigen Potentialdifferenzwerts bestimmt. Auch hierdurch wird in vorteilhafter Weise eine rechentechnische Durchführung des Verfahrens vereinfacht. Insbesondere kann jedoch eine der vorhergehend erläuterten Fehlerarten einem oder mehreren Potentialdifferenzintervallen zugeordnet sein. Somit ergibt sich in vorteilhafter Weise eine vereinfachte Klassifikation einer Fehlerart.

In einer weiteren Ausführungsform wird für jede Phasenleitung eine Potentialdifferenz zwischen einem maschinenseitigen Teil der Phasenleitung und einem Bezugspotential und eine potentialdifferenzabhängige Größe bestimmt. Weiter wird ein kombiniertes Ausgangssignal gebildet, wobei das kombinierte Ausgangssignal eine erste Bitfolge umfasst, die die aus der minimalen Potentialdifferenz gebildete potentialdifferenzabhängige Größe kodiert. Diese Bitfolge kann eine vorbestimmte Anzahl von Bits, beispielsweise 3 Bits, umfassen. Weiter umfasst das kombinierte Ausgangssignal eine weitere Bitfolge, die eine Gleichheit aller Potentialdifferenzen kodiert. Die weitere Bitfolge kann insbesondere aus genau einem Bit bestehen, wobei einer der beiden Zustände des Bits, beispielsweise der Zustand "1" oder der Zustand "0", eine Gleichheit aller Potentialdifferenzen kodiert.

Hierdurch ergibt sich in vorteilhafter Weise eine einfache Kodierung des Ausgangssignals, welches einerseits eine Detektion eines Netzwerkfehlers und andererseits die Detektion eines dreiphasigen oder zweiphasigen Netzwerkfehlers vereinfacht.

In einer weiteren Ausführungsform ist die potentialdifferenzabhängige Größe eine maximale Amplitude oder ein RMS-Wert der Potentialdifferenz während einer vorbestimmten Bestimmungszeitdauer. Die Bestimmungszeitdauer kann beispielsweise in einem Intervall von 10 ms bis 100 ms liegen. Vorzugsweise beträgt die Bestimmungszeitdauer 100 ms.

Die potentialdifferenzabhängige Größe kann hierbei als digitales Signal bereitgestellt werden. Auch kann die potentialdifferenzabhängige Größe umgekehrt proportional zur Höhe der Potentialdifferenz erzeugt werden.

Weiter kann die drehzahlabhängige Größe zusätzlich in Abhängigkeit einer Temperatur der Permanentmagnetmaschine bestimmt werden. Alternativ oder kumulativ kann die drehzahlabhängige Referenzgröße in Abhängigkeit eines Alters der Permanentmagnetmaschine bestimmt werden. Hierbei kann davon ausgegangen werden, dass die von der Permanentmagnetmaschine in Abhängigkeit der Drehzahl erzeugte Leerlaufspannung zusätzlich abhängig von einer Betriebstemperatur der Permanentmagnetmaschine und/oder abhängig von einem Alter der Permanentmagnetmaschine ist. Somit kann das vorgeschlagene Verfahren weiter in seiner Genauigkeit und Zuverlässigkeit verbessert werden.

Weiter vorgeschlagen wird eine Vorrichtung zur Überwachung eines elektrischen Netzwerks in einem Schienenfahrzeug. Das elektrische Netzwerk kann hierbei wie vorhergehend erläutert ausgebildet sein.

Die Vorrichtung umfasst mindestens eine Auswerteeinrichtung, mindestens eine Bestimmungseinrichtung und mindestens eine Unterbrechungseinrichtung. Mittels der Unterbrechungseinrichtung ist die erste Phasenleitung unterbrechbar. Mittels der Bestimmungseinrichtung ist eine Potentialdifferenz zwischen einem maschinenseitigen Teil der Phasenleitung und einem Bezugspotential bestimmbar.

Weiter ist eine potentialdifferenzabhängige Größe bestimmbar. Die potentialdifferenzabhängige Größe kann hierbei beispielsweise durch die Bestimmungseinrichtung bestimmt werden. So kann die potentialdifferenzabhängige Größe beispielsweise in Form eines Ausgangssignals, insbesondere eines digitalen Ausgangssignals, der Bestimmungseinrichtung bereitgestellt werden. Alternativ kann die potentialdifferenzabhängige Größe jedoch auch durch die Auswerteeinrichtung bestimmt werden.

Die Auswerteinrichtung und die mindestens eine Bestimmungseinrichtung sind hierbei daten- und/oder signaltechnisch verbunden. Auch können die Auswerteeinrichtung und die Bestimmungseinrichtung als gemeinsame Einrichtung gebildet sein.

Weiter ist eine Drehzahl der Permanentmagnetmaschine und in Abhängigkeit der Drehzahl eine drehzahlabhängige Referenzgröße bestimmbar. Hierbei kann die Vorrichtung eine Drehzahlbestimmungseinrichtung umfassen.

Die Bestimmung der drehzahlabhängigen Referenzgröße kann hierbei ebenfalls mittels der Bestimmungseinrichtung oder mittels der Auswerteeinrichtung durchgeführt werden.

Weiter ist mittels der Auswerteeinrichtung eine Abweichung der potentialdifferenzabhängigen Größe von der drehzahlabhängigen Referenzgröße bestimmbar. Weiter ist ein Netzwerkfehler detektierbar, falls die Abweichung größer als ein vorbestimmter Schwellwert ist.

Die Vorrichtung ermöglicht hierbei in vorteilhafter Weise die Durchführung eines der vorhergehend beschriebenen Verfahren. Somit ist die Vorrichtung derart ausgebildet, dass das Verfahren gemäß einer der vorhergehend erläuterten Ausführungsformen mittels der Vorrichtung durchführbar ist.

In einer bevorzugten Ausführungsform wird die Potentialdifferenz motornah bestimmt. Dies kann bedeuten, dass ein Bestimmungspunkt für die Bestimmung der Potentialdifferenz nicht mehr als eine vorbestimmte Distanz von einem Anschlusspunkt der Phasenleitung an die Permanentmagnetmaschine beabstandet angeordnet ist, wobei die Distanz entlang der Phasenleitung gemessen wird.

Hierdurch ergibt sich in vorteilhafter Weise eine sehr geringe Wahrscheinlichkeit einer fehlerhaften Detektion eines Netzwerkfehlers aufgrund eines Fehlers in der Verkabelung zwischen Spannungssensor und Permanentmagnetmotor.

Weiter vorgeschlagen wird ein Schienenfahrzeug, wobei das Schienenfahrzeug eine Vorrichtung gemäß einer der vorhergehend erläuterten Ausführungsformen umfasst. Hierdurch ergibt sich in vorteilhafter Weise ein Schienenfahrzeug, dessen Betriebssicherheit erhöht ist.

Die Erfindung wird anhand eines Ausführungsbeispiels näher erläutert. Die Figuren zeigen:
- Fig. 1: ein schematisches Schaltbild eines elektrischen Netzwerks eines Schienenfahrzeugs,
- Fig. 2: ein schematisches Blockschaltbild einer erfindungsgemäßen Vorrichtung und
- Fig. 3: eine schematische Darstellung von Drehzahlintervallen und Spannungsintervallen.
Nachfolgend bezeichnen gleiche Bezugszeichen Elemente mit gleichen oder ähnlichen technischen Merkmalen.

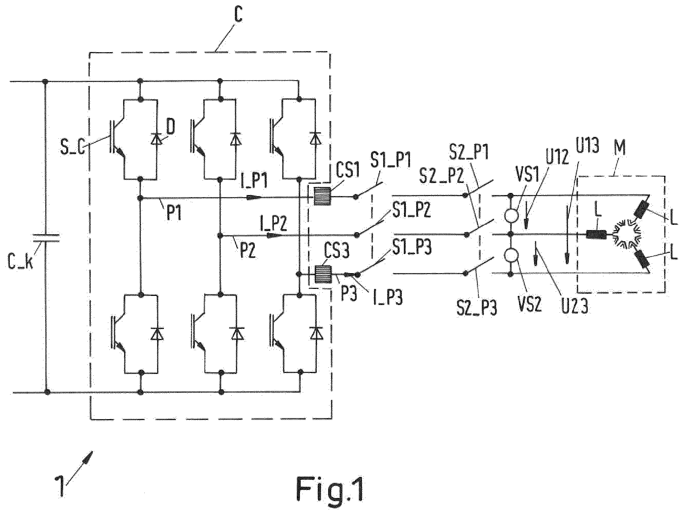

In Fig. 1 ist ein elektrisches Netzwerk 1 eines Schienenfahrzeugs (nicht dargestellt) dargestellt. Das elektrische Netzwerk 1 umfasst einen Stromrichter C und eine Permanentmagnetmaschine M, wobei exemplarisch Induktivitäten L der Permanentmagnetmaschine M dargestellt sind. Weiter umfasst das elektrische Netzwerk 1 einen Zwischenkreiskondensator C_k. Der Stromrichter C ist eingangsseitig mit einem Zwischenkreiskondensator C_k verbunden.

Der Stromrichter C ist hierbei ein dreiphasiger Stromrichter. Dieser umfasst sechs elektrische Schaltelemente S_C, zu denen jeweils elektrisch parallel eine Freilaufdiode D geschaltet ist. Der Übersichtlichkeit halber sind nur ein elektrisches Schaltelement S_C und eine Diode D des Stromrichters C mit einem Bezugszeichen versehen.

Weiter umfasst das elektrische Netzwerk 1 drei Phasenleitungen P1, P2, P3. Dargestellt sind weiter Phasenströme I_P1, I_P2 und I_P3, die einen Stromfluss durch die entsprechende Phasenleitung P1, P2, P3 visualisieren.

Weiter umfasst das elektrische Netzwerk 1 einen ersten Stromsensor CS1 und einen weiteren Stromsensor CS3, wobei der erste Stromsensor CS1 den ersten Phasenstrom I_P1 und der weitere Stromsensor CS3 den dritten Phasenstrom I_P3 erfasst.

Mittels der Phasenleitungen P1, P2, P3 ist der Stromrichter C ausgangsseitig mit der Permanentmagnetmaschine M verbunden. Somit ist die Permanentmagnetmaschine M eine dreiphasige elektrische Maschine.

In der ersten Phasenleitung P1 sind ein erstes elektrisches Schaltelement S1_P1 und ein zweites elektrisches Schaltelement S2_P1 angeordnet. Durch Öffnen und Schließen dieser beiden Schaltelemente S1_P1, S2_P1 kann die elektrische Verbindung über die erste Phasenleitung P1 zwischen dem Stromrichter C und der Permanentmagnetmaschine M hergestellt oder unterbrochen werden. In einem geschlossenen Zustand der Schaltelemente S1_P1, S2_P1 ist die elektrische Verbindung hierbei hergestellt. Ist mindestens einer der beiden Schaltelemente S1_P1, S2_P1 geöffnet, so ist die elektrische Verbindung unterbrochen. Hierbei kann das erste Schaltelement S1_P1 einen sogenannten Motorschalter bezeichnen. Das zweite Schaltelement S2_P1 kann einen weiteren Motorschalter bezeichnen.

Entsprechend sind in weiteren Phasenleitungen P2, P3 ebenfalls jeweils ein erstes elektrisches Schaltelement S1_P2, S1_P3 und ein zweites elektrisches Schaltelement S2_P2, S2_P3 angeordnet.

Weiter dargestellt sind ein erster Spannungssensor VS1 und ein zweiter Spannungssensor VS2. Der erste Spannungssensor VS1 erfasst eine Spannung U12, also eine Potentialdifferenz, zwischen der ersten Phasenleitung P1 und der zweiten Phasenleitung P2. Entsprechend erfasst der zweite Spannungssensor VS2 eine Spannung U23 zwischen der zweiten Phasenleitung P2 und der dritten Phasenleitung P3.

Zur Überwachung des elektrischen Netzwerks 1 wird mindestens ein elektrisches Schaltelement, vorzugsweise beide elektrische Schaltelemente S1_P1, ..., S2_P3, jeder Phasenleitung P1, P2, P3 geöffnet. Dann werden die Spannungen U12, U23 erfasst und eine Spannung U13 zwischen der ersten Phasenleitung P1 und der dritten Phasenleitung P3 berechnet.

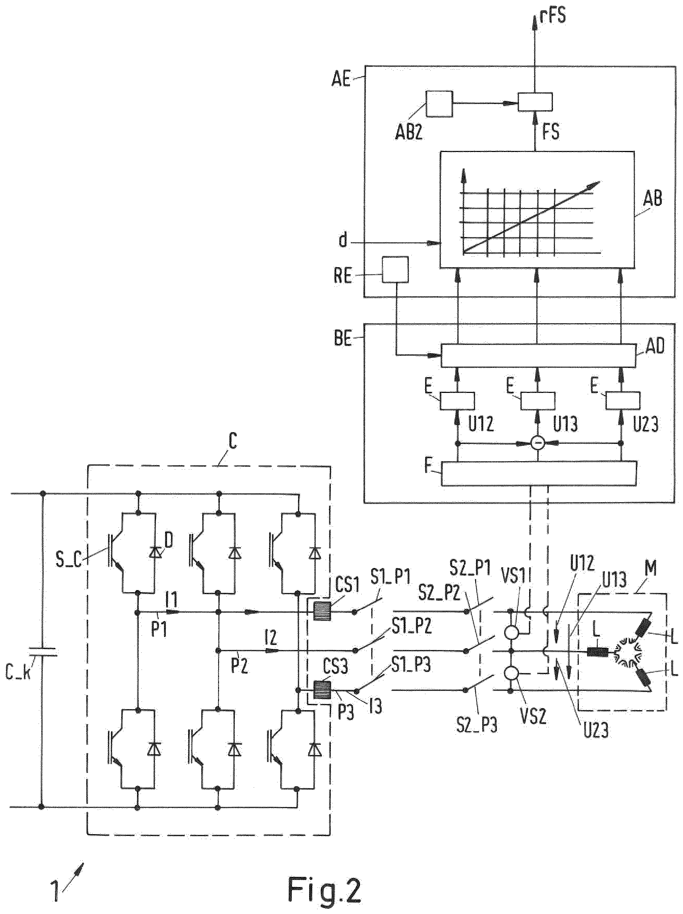

Weiter wird eine Drehzahl d (siehe Fig. 2) der Permanentmagnetmaschine M bestimmt.

Weiter wird für jede der Spannungen U12, U23, U13 eine spannungsabhängige Größe bestimmt, beispielsweise ein maximaler Absolutwert während eines vorbestimmten Zeitintervalls von 100 ms, welches sich z.B. an einen Bestimmungs-Startzeitpunkt anschließt.

In Abhängigkeit der Drehzahl d der Permanentmagnetmaschine M wird eine drehzahlabhängige Referenzgröße bestimmt. Die Referenzgröße korrespondiert hierbei zu der spannungsabhängigen Größe. Beispielsweise kann die drehzahlabhängige Referenzgröße einen minimalen Absolutwert einer Leerlaufspannung der Permanentmagnetmaschine M in dem vorbestimmten Zeitintervall von 100 ms sein.

Wie in Fig. 2 näher erläutert, wird dann eine Differenz der zwischen der drehzahlabhängigen Referenzgröße und der spannungsabhängigen Größe bestimmt und ein Netzwerkfehler detektiert, falls die Differenz größer als ein vorbestimmter Schwellwert, insbesondere größer als Null, ist.

In Fig. 2 ist das elektrische Netzwerk 1 aus Fig. 1 sowie eine Bestimmungseinrichtung BE und eine Auswerteeinrichtung AE dargestellt. Hinsichtlich der Ausbildung des elektrischen Netzwerks 1 wird hierbei auf die Ausführungen zu Fig. 1 verwiesen.

Die Bestimmungseinrichtung BE, die beispielsweise als Mikrocontroller oder Teil davon ausgebildet sein kann, ist signaltechnisch mit den Spannungssensoren VS1, VS2 verbunden. Die Spannung U12 zwischen der ersten Phasenleitung P1 und der zweiten Phasenleitung P2 und die Spannung U23 zwischen der zweiten Phasenleitung P2 und der dritten Phasenleitung P3 bilden Eingangssignale für die Bestimmungseinrichtung BE. Diese werden von einer Filtereinheit F gefiltert. Weiter dargestellt ist, dass nach der Filterung eine Differenzbildung zur Bestimmung der Spannung U13 zwischen der ersten Phasenleitung P1 und der dritten Phasenleitung P3 erfolgt. In den Einheiten E wird zur Bestimmung der spannungsabhängigen Größe ein maximaler Betrag einer Amplitude der Spannungen U12, U23, U13 in einem Intervall von 100 ms bestimmt. In einem AD-Wandler AD erfolgt eine Digitalisierung dieser spannungsabhängigen Größen. Hierbei erfolgt die Digitalisierung umgekehrt proportional zu einer Höhe der spannungsabhängigen Größen. Insbesondere ist ein Wert der spannungsabhängigen Größe von Null mit dem höchsten digitalen Wert kodiert. Die Digitalisierung kann unter Verwendung eines Gray-Codes erfolgen.

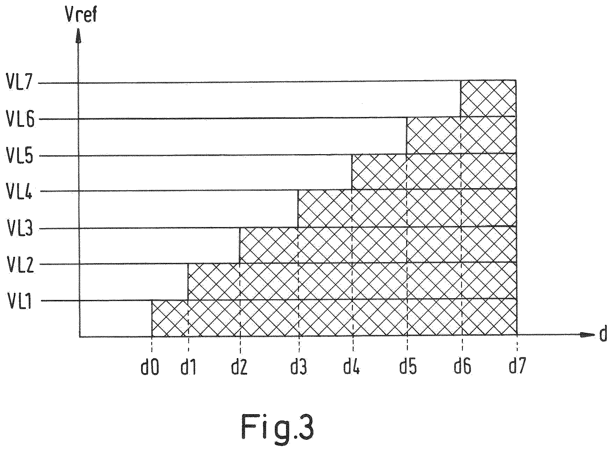

Diese digitalen Werte, die die spannungsabhängigen Größen repräsentieren, bilden Ausgangssignale der Bestimmungseinrichtung BE und Eingangssignale der Auswerteeinrichtung AE, die datentechnisch mit der Bestimmungseinrichtung BE verbunden ist. Ein weiteres Eingangssignal der Auswerteeinrichtung AE ist eine Drehzahl d der Permanentmagnetmaschine M. Über einen vorbekannten Zusammenhang, der in Fig. 2 exemplarisch in dem Auswerteblock AB dargestellt ist, bestimmt die Auswerteeinrichtung AE eine drehzahlabhängige Referenzgröße Vref (siehe Fig. 3).

Weiter wird bestimmt, ob die drehzahlabhängige Referenzgröße Vref um mehr als ein vorbestimmtes Maß größer ist als jede der übermittelten spannungsabhängigen Größen. Ist die drehzahlabhängige Referenzgröße Vref größer als mindestens eine der übermittelten spannungsabhängigen Größen, so wird ein Fehlersignal FS erzeugt. In Fig. 2 ist weiter dargestellt, dass durch einen weiteren Auswerteblock AB2 geprüft wird, ob die Permanentmagnetmaschine M nicht mit dem Stromrichter C verbunden ist, beispielsweise ob alle Schalter S1_P1, ..., S2_P3 geöffnet sind. Auch kann überprüft werden, ob kein Rückmeldesignal, welches auch als "life signal" bezeichnet werden kann, von einer nicht dargestellten Traktionssteuereinrichtung vorhanden ist. Beispielsweise kann detektiert werden, dass die Schalter S1_P1, ..., S2_P3 geöffnet sind, falls ein solches Rückmeldesignal nicht vorhanden ist.

Ist mindestens eine der Bedingungen erfüllt, so wird von der Auswerteeinrichtung AE ein resultierendes Fehlersignal rFS ausgegeben. In Abhängigkeit dieses resultierenden Fehlersignals rFS kann dann eine entsprechende Schutzmaßnahme eingeleitet werden.

Weiter dargestellt ist eine Referenzsignalerzeugungseinrichtung RE, die Teil der Auswerteeinrichtung AE ist. Diese übermittelt ein Referenzsignal, beispielsweise ein Sprungsignal, an den Digitalwandler AD. Dies kann beispielsweise bei Inbetriebnahme der Auswerteeinrichtung AE und der Bestimmungseinrichtung BE erfolgen. Hierdurch kann eine Funktionsfähigkeit des Digitalwandlers AD überprüft werden.

Auch kann zur Prüfung der Funktionsfähigkeit überprüft werden, ob sich ein Bitmuster des digitalisierten Ausgangssignals der Bestimmungseinrichtung DE um maximal 1 Bit ändert, insbesondere wenn zur Digitalisierung ein sogenannter Gray-Code verwendet wird.

Nicht dargestellt ist, dass durch die Bestimmungseinrichtung BE und die Auswerteeinrichtung AE auch ein weiteres elektrisches Netzwerk überwacht werden kann, welches z.B. ebenfalls einen Stromrichter C, Phasenleitungen P1, P2, P3 und eine Permanentmagnetmaschine M umfasst. So kann die Bestimmungseinrichtung BE und die Auswerteeinrichtung AE zur Überwachung mehrerer elektrischer Netzwerke, die jeweils eine Permanentmagnetmaschine M zum Antrieb des Schienenfahrzeugs umfassen, dienen. Auch ist denkbar, dass mehrere Permanentmagnetmaschinen eines Drehgestells überwacht werden.

In Fig. 3 ist schematisch ein Zusammenhang zwischen einer Drehzahl d und einer drehzahlabhängigen Referenzgröße Vref dargestellt. Die drehzahlabhängige Referenzgröße Vref kann insbesondere eine Spannung sein. Die bei einer bestimmten Drehzahl d induzierte Spannung hängt näherungsweise linear von der Motordrehzahl ab. Allerdings können auch Alterungseinflüsse und Temperatur, insbesondere eine Magnettemperatur, die induzierte Spannung beeinflussen. So kann beispielsweise die drehzahlabhängige Referenzgröße Vref als eine minimale drehzahlabhängige Spannung definiert werden, die bei einer im Normalbetrieb maximal auftretenden Magnettemperatur, induziert wird. Alternativ oder kumulativ kann die drehzahlabhängige Referenzgröße Vref auch in Abhängigkeit vom Alter der Permanentmagnetmaschine bestimmt werden, wobei sich die drehzahlabhängige Referenzgröße mit zunehmendem Alter verringert. Dieser Zusammenhang kann jedoch vorbekannt sein. Hierdurch ergibt sich in vorteilhafter Weise, dass eine Zuverlässigkeit und eine Robustheit des Verfahrens erhöht werden kann.

Weiter ist dargestellt, dass aufgrund der Digitalisierung die Drehzahl d einem Drehzahlintervall von mehreren Drehzahlintervallen zugewiesen werden kann, wobei die Drehzahlintervalle von vorbestimmten Drehzahlen d0, d1, d2, d3, d4, d5, d6, d7 begrenzt werden. Jedem Drehzahlintervall ist eine intervallabhängige Referenzgröße VL1, VL2, VL3, VL4, VL5, VL6, VL7 zugewiesen. Beispielsweise ist einem ersten Drehzahlintervall, welches zwischen der ersten Drehzahl d0 und einer zweiten Drehzahl d1 liegt, eine erste intervallabhängige Referenzgröße VL1 zugewiesen. Liegt die Drehzahl also in diesem ersten Drehzahlintervall, so wird die drehzahlabhängige Referenzgröße Vref als diese intervallabhängige Referenzgröße VL1 bestimmt.

## Patentansprüche

1. Verfahren zur Überwachung eines elektrischen Netzwerks (1) in einem Schienenfahrzeug, wobei das elektrische Netzwerk (1) drei Phasenleitungen (P1, P2, P3), mindestens einen Stromrichter (C), mindestens eine Permanentmagnetmaschine (M), mindestens eine Unterbrechungseinrichtung (S1_P1, S1_P2, S1_P3; S2_P1, S2_P2, S2_P3) und mindestens eine erste Phasenleitung (P1) zur elektrischen Verbindung des mindestens einen Stromrichters (C) und des mindestens einen Permanentmagnetmaschine (M) umfasst, das Verfahren **gekennzeichnet dadurch, daß**
die erste Phasenleitung (P1) unterbrochen wird, wobei eine Potentialdifferenz zwischen einem maschinenseitigen Teil der ersten Phasenleitung (P1) und einem Bezugspotential und eine potentialdifferenzabhängige Größe bestimmt wird,
wobei eine Drehzahl (d) der Permanentmagnetmaschine (M) und in Abhängigkeit der Drehzahl (d) eine drehzahlabhängige Referenzgröße (Vref) bestimmt wird,
wobei eine Abweichung der potentialdifferenzabhängigen Größe von der drehzahlabhängigen Referenzgröße (Vref) bestimmt wird, wobei ein Netzwerkfehler detektiert wird, falls die Abweichung größer als ein vorbestimmter Schwellwert ist,
wobei mindestens zwei oder alle Phasenleitungen (P1, P2, P3) unterbrochen werden, wobei für jede Phasenleitung (P1, P2, P3) eine Potentialdifferenz zwischen einem maschinenseitigen Teil der Phasenleitung (P1, P2, P3) und einem Bezugspotential bestimmt wird, wobei eine Drehzahl (d) der Permanentmagnetmaschine (M) und in Abhängigkeit der Drehzahl (d) eine drehzahlabhängige Referenzgröße (Vref) für jede Phasenleitung (P1, P2, P3) bestimmt wird, wobei für jede Phasenleitung (P1, P2, P3) eine potentialdifferenzabhängige Größe und eine Abweichung der potentialdifferenzabhängigen Größe von der drehzahlabhängigen Referenzgröße (Vref) bestimmt und ein Netzwerkfehler detektiert wird, falls mindestens eine der Abweichungen größer als ein vorbestimmter Schwellwert ist und/oder wobei eine minimale Potentialdifferenz aller Potentialdifferenzen und eine von dieser minimalen Potentialdifferenz abhängige Größe bestimmt wird, wobei eine Abweichung der von dieser minimalen Potentialdifferenz abhängigen Größe von der drehzahlabhängigen Referenzgröße (Vref) bestimmt und ein Netzwerkfehler detektiert wird, falls diese Abweichung größer als ein vorbestimmter Schwellwert ist, wobei in Abhängigkeit der Potentialdifferenzen und/oder der mindestens einen Abweichung ein zweiphasiger Netzwerkfehler oder ein dreiphasiger Netzwerkfehler bestimmt wird.

2. Verfahren nach Anspruch 1, **dadurch gekennzeichnet, dass** bei Detektion eines Netzwerkfehlers eine Drehzahl (d) der Permanentmagnetmaschine (M) reduziert wird und/oder eine weitere Unterbrechung des maschinenseitigen Teils der Phasenleitung (P1, P2, P3) durchgeführt wird.

3. Verfahren nach einem der vorangegangenen Ansprüche, **dadurch gekennzeichnet, dass** eine Genauigkeit der Bestimmung der Potentialdifferenz überprüft wird, indem bei einer ununterbrochenen Phasenleitung (P1, P2, P3) mindestens eine Normalbetriebs-Potentialdifferenz bestimmt wird, wobei eine Abweichung der Normalbetriebs-Potentialdifferenz von einem Normalbetriebs-Referenzwert bestimmt wird, wobei eine ausreichende Genauigkeit detektiert wird, falls die Abweichung kleiner als ein oder gleich einem vorbestimmten Schwellwert ist und/oder indem ein Stillstand der Permanentmagnetmaschine (M) detektiert wird, wobei bei einer unterbrochenen Phasenleitung (P1, P2, P3) mindestens eine Stillstands-Potentialdifferenz erfasst wird, wobei eine Abweichung der Stillstands-Potentialdifferenz von einem Stillstands-Referenzwert bestimmt wird, wobei eine ausreichende Genauigkeit detektiert wird, falls die Abweichung kleiner als ein oder gleich einem vorbestimmten Schwellwert ist.

4. Verfahren nach einem der vorangegangenen Ansprüche, **dadurch gekennzeichnet, dass** die Drehzahl (d) einem Drehzahlintervall von mehreren Drehzahlintervallen zugewiesen wird, wobei einem Drehzahlintervall eine intervallabhängige Referenzgröße zugewiesen ist, wobei die drehzahlabhängige Referenzgröße (Vref) als die intervallabhängige Referenzgröße bestimmt wird.

5. Verfahren nach einem der vorangegangenen Ansprüche, **dadurch gekennzeichnet, dass** die Potentialdifferenz einem Potentialdifferenzintervall von mehreren Potentialdifferenzintervallen zugewiesen wird, wobei einem Potentialdifferenzintervall eine intervallabhängiger Potentialdifferenzwert zugewiesen ist, wobei die potentialdifferenzabhängige Größe in Abhängigkeit des intervallabhängigen Potentialdifferenzwerts bestimmt wird.

6. Verfahren nach einem vorangegangenen Ansprüche, **dadurch gekennzeichnet, dass** für jede Phasenleitung (P1, P2, P3) eine Potentialdifferenz zwischen einem maschinenseitigen Teil der Phasenleitung (P1, P2, P3) und einem Bezugspotential und eine potentialdifferenzabhängige Größe bestimmt wird, wobei ein kombiniertes Ausgangssignal gebildet wird, wobei das kombinierte Ausgangssignal eine erste Bitfolge umfasst, die die aus der minimalen Potentialdifferenz gebildete potentialdifferenzabhängige Größe kodiert, wobei das kombinierte Ausgangssignal eine weitere Bitfolge umfasst, die eine Gleichheit aller Potentialdifferenzen kodiert.

7. Verfahren nach einem der vorhergehenden Ansprüche, **dadurch gekennzeichnet, dass** die potentialdifferenzabhängige Größe eine maximale Amplitude oder ein RMS-Wert der Potentialdifferenz während einer vorbestimmten Bestimmungszeitdauer ist.

8. Vorrichtung zur Überwachung eines elektrischen Netzwerks (1) in einem Schienenfahrzeug, wobei das elektrische Netzwerk (1) drei Phasenleitungen (P1, P2, P3), mindestens einen Stromrichter (C), mindestens eine Permanentmagnetmaschine (M) und mindestens eine erste Phasenleitung (P1) zur elektrischen Verbindung des mindestens einen Stromrichters (C) und der mindestens einen Permanentmagnetmaschine (M) und mindestens eine Unterbrechungseinrichtung (S1_P1, S1_P2, S1_P3; S2_P1, S2_P2, S2_P3) umfasst, wobei mittels der Unterbrechungseinrichtung die erste Phasenleitung (P1) unterbrechbar ist, **gekennzeichnet dadurch, daß**
die Vorrichtung mindestens eine Auswerteeinrichtung (AE) und mindestens eine Bestimmungseinrichtung (BE) umfaßt, wobei mittels der Bestimmungseinrichtung (BE) eine Potentialdifferenz zwischen einem maschinenseitigen Teil der ersten Phasenleitung (P1) und einem Bezugspotential bestimmbar ist, wobei weiter eine potentialdifferenzabhängige Größe bestimmbar ist, wobei eine Drehzahl (d) der Permanentmagnetmaschine (M) und in Abhängigkeit der Drehzahl (d) eine drehzahlabhängige Referenzgröße (Vref) bestimmbar ist, wobei mittels der Auswerteeinrichtung (AE) eine Abweichung der potentialdifferenzabhängigen Größe von der drehzahlabhängigen Referenzgröße (Vref) bestimmbar ist, wobei ein Netzwerkfehler detektierbar ist, falls die Abweichung größer als ein vorbestimmter Schwellwert ist, wobei mindestens zwei oder alle Phasenleitungen (P1, P2, P3) unterbrechbar sind, wobei für jede Phasenleitung (P1, P2, P3) eine Potentialdifferenz zwischen einem maschinenseitigen Teil der Phasenleitung (P1, P2, P3) und einem Bezugspotential bestimmbar ist, wobei eine Drehzahl (d) der Permanentmagnetmaschine (M) und in Abhängigkeit der Drehzahl (d) eine drehzahlabhängige Referenzgröße (Vref) für jede Phasenleitung (P1, P2, P3) bestimmbar ist, wobei für jede Phasenleitung (P1, P2, P3) eine potentialdifferenzabhängige Größe und eine Abweichung der potentialdifferenzabhängigen Größe von der drehzahlabhängigen Referenzgröße (Vref) bestimmbar und ein Netzwerkfehler detektierbar ist, falls mindestens eine der Abweichungen größer als ein vorbestimmter Schwellwert ist und/oder wobei eine minimale Potentialdifferenz aller Potentialdifferenzen und eine von dieser minimalen Potentialdifferenz abhängige Größe bestimmbar ist, wobei eine Abweichung der von dieser minimalen Potentialdifferenz abhängigen Größe von der drehzahlabhängigen Referenzgröße (Vref) bestimmbar und ein Netzwerkfehler detektierbar ist, falls diese Abweichung größer als ein vorbestimmter Schwellwert ist, wobei in Abhängigkeit der Potentialdifferenzen und/oder der mindestens einen Abweichung ein zweiphasiger Netzwerkfehler oder ein dreiphasiger Netzwerkfehler bestimmbar ist.

9. Vorrichtung nach Anspruch 8, **dadurch gekennzeichnet, dass** die Potentialdifferenz motornah bestimmt wird.

10. Schienenfahrzeug, umfassend eine Vorrichtung nach einem der Ansprüche 8 oder 9.

## Claims

1. A method for monitoring an electrical network (1) in a rail vehicle, the electrical network (1) comprising three phase lines (P1, P2, P3), at least one power converter (C), at least one permanent magnet machine (M), at least one interruption unit (S1_P1, S1_P2, S1_P3; S2_P1, S2_P2, S2_P3) and at least one first phase line (P1) for electrically connecting the at least one power converter (C) and the at least one permanent magnet machine (M), the method being **characterized in that** the first phase line (P1) is interrupted, wherein a potential difference between a machine-side part of the first phase line (P1) and a reference potential and a potential-difference-dependent variable are determined,
wherein a speed (d) of the permanent magnet machine (M) and, as a function of the speed (d), a speed-dependent reference variable (Vref) are determined, wherein a deviation of the potential-difference-dependent variable from the speed-dependent reference variable (Vref) is determined, wherein a network fault is detected if the deviation is greater than a predetermined threshold value,
wherein at least two or all phase lines (P1, P2, P3) are interrupted, wherein a potential difference between a machine-side part of the phase line (P1, P2, P3) and a reference potential is determined for each phase line (P1, P2, P3), wherein a speed (d) of the permanent magnet machine (M) and, as a function of the speed (d), a speed-dependent reference variable (Vref) are determined for each phase line (P1, P2, P3), wherein a potential-difference-dependent variable and a deviation of the potential-difference-dependent variable from the speed-dependent reference variable (Vref) are determined for each phase line (P1, P2, P3), and a network fault is detected if at least one of the deviations is greater than a predetermined threshold value, and/or wherein a minimum potential difference of all potential differences and a variable dependent on this minimum potential difference are determined, wherein a deviation of the variable dependent on this minimum potential difference from the speed-dependent reference variable (Vref) is determined, and a network fault is detected if this deviation is greater than a predetermined threshold value, wherein a two-phase network fault or a three-phase network fault is determined as a function of the potential differences and/or the at least one deviation.

2. The method according to claim 1, **characterized in that**, upon detection of a network fault, a speed (d) of the permanent magnet machine (M) is reduced and/or a further interruption of the machine-side part of the phase line (P1, P2, P3) is carried out.

3. The method according to any one of the preceding claims, **characterized in that** an accuracy of the determination of the potential difference is checked by determining at least one normal operation potential difference in the case of an uninterrupted phase line (P1, P2, P3), wherein a deviation of the normal operation potential difference from a normal operation reference value is determined, wherein a sufficient accuracy is detected if the deviation is smaller than or equal to a predetermined threshold value, and/or by detecting a standstill of the permanent magnet machine (M), wherein at least one standstill potential difference is detected in the case of an interrupted phase line (P1, P2, P3), wherein a deviation of the standstill potential difference from a standstill reference value is determined, wherein a sufficient accuracy is detected if the deviation is smaller than or equal to a predetermined threshold value.

4. The method according to any one of the preceding claims, **characterized in that** the speed (d) is assigned to one speed interval of a plurality of speed intervals, wherein an interval-dependent reference variable is assigned to one speed interval, wherein the speed-dependent reference variable (Vref) is determined as the interval-dependent reference variable.

5. The method according to any one of the preceding claims, **characterized in that** the potential difference is assigned to one potential difference interval of a plurality of potential difference intervals, wherein an interval-dependent potential difference value is assigned to one potential difference interval, wherein the potential-difference-dependent variable is determined as a function of the interval-dependent potential difference value.

6. The method according to any one of the preceding claims, **characterized in that** a potential difference between a machine-side part of the phase line (P1, P2, P3) and a reference potential and a potential-difference-dependent variable are determined for each phase line (P1, P2, P3), wherein a combined output signal is formed, wherein the combined output signal comprises a first bit sequence, which codes the potential-difference-dependent variable formed from the minimum potential difference, wherein the combined output signal comprises a further bit sequence, which codes an equality of all potential differences.

7. The method according to any one of the preceding claims, **characterized in that** the potential-difference-dependent variable is a maximum amplitude or an RMS value of the potential difference during a predetermined determination duration.

8. A device for monitoring an electrical network (1) in a rail vehicle, the electrical network (1) comprising three phase lines (P1, P2, P3), at least one power converter (C), at least one permanent magnet machine (M), and at least one first phase line (P1) for electrically connecting the at least one power converter (C) and the at least one permanent magnet machine (M), and at least one interruption unit (S1_P1, S1_P2, S1_P3; S2_P1, S2_P2, S2_P3), the first phase line (P1) being interruptible by means of the interruption unit, **characterized in that** the device comprises at least one evaluation unit (AE) and at least one determination unit (BE), wherein a potential difference between a machine-side part of the first phase line (P1) and a reference potential is determinable by means of the determination unit (BE), wherein furthermore a potential-difference-dependent variable is determinable, wherein a speed (d) of the permanent magnet machine (M) and, as a function of the speed (d), a speed-dependent reference variable (Vref) are determinable, wherein a deviation of the potential-difference-dependent variable from the speed-dependent reference variable (Vref) is determinable by means of the evaluation unit (AE), wherein a network fault is detectable if the deviation is greater than a predetermined threshold value, wherein at least two or all phase lines (P1, P2, P3) are interruptible, wherein a potential difference between a machine-side part of the phase line (P1, P2, P3) and a reference potential is determinable for each phase line (P1, P2, P3), wherein a speed (d) of the permanent magnet machine (M) and, as a function of the speed (d), a speed-dependent reference variable (Vref) are determinable for each phase line (P1, P2, P3), wherein a potential-difference-dependent variable and a deviation of the potential-difference-dependent variable from the speed-dependent reference variable (Vref) are determinable for each phase line (P1, P2, P3), and a network fault is detectable if at least one of the deviations is greater than a predetermined threshold value, and/or wherein a minimum potential difference of all potential differences and a variable dependent on this minimum potential difference are determinable, wherein a deviation of the variable dependent on this minimum potential difference from the speed-dependent reference variable (Vref) is determinable, and a network fault is detectable if this deviation is greater than a predetermined threshold value, wherein a two-phase network fault or a three-phase network fault is determinable as a function of the potential differences and/or the at least one deviation.

9. The device according to claim 8, **characterized in that** the potential difference is determined close to the motor.

10. A rail vehicle, comprising a device according to any one of claims 8 to 9.

## Revendications

1. Procédé de surveillance d'un réseau électrique (1) dans un véhicule ferroviaire, dans lequel le réseau électrique (1) comporte trois lignes de phase (P1, P2, P3), au moins un convertisseur (C), au moins une machine à aimants permanents (M), au moins un dispositif d'interruption (S1_P1, S1_P2, S1_P3 ; S2_P1, S2_P2, S2_P3) et au moins une première ligne de phase (P1) pour la liaison électrique de l'au moins un convertisseur (C) et de l'au moins une machine à aimants permanents (M), le procédé étant **caractérisé en ce que** la première ligne de phase (P1) est interrompue, dans lequel une différence de potentiel entre une partie côté machine de la première ligne de phase (P1) et un potentiel de référence et une grandeur dépendant de la différence de potentiel sont déterminées,
dans lequel une vitesse de rotation (d) de la machine à aimants permanents (M) et en fonction de la vitesse de rotation (d) une grandeur de référence dépendant de la vitesse de rotation (Vref) sont déterminées, dans lequel un écart de la grandeur dépendant de la différence de potentiel de la grandeur de référence dépendant de la vitesse de rotation (Vref) est déterminé, dans lequel une erreur de réseau est détectée dans le cas où l'écart est supérieur à une valeur seuil prédéterminée, dans lequel au moins deux ou toutes les lignes de phase (P1, P2, P3) sont interrompues, dans lequel pour chaque ligne de phase (P1, P2, P3) une différence de potentiel entre une partie côté machine de la ligne de phase (P1, P2, P3) et un potentiel de référence est déterminée, dans lequel une vitesse de rotation (d) de la machine à aimants permanents (M) et en fonction de la vitesse de rotation (d) une grandeur de référence dépendant de la vitesse de rotation (Vref) pour chaque ligne de phase (P1, P2, P3) sont déterminées, dans lequel pour chaque ligne de phase (P1, P2, P3) une grandeur dépendant de la différence de potentiel et un écart de la grandeur dépendant de la différence de potentiel de la grandeur de référence dépendant de la vitesse de rotation (Vref) sont déterminés et une erreur de réseau est détectée dans le cas où au moins un des écarts est supérieur à une valeur seuil prédéterminée et/ou dans lequel une différence de potentiel minimale de toutes les différence de potentiel et une grandeur dépendant de cette différence de potentiel minimale sont déterminées, dans lequel un écart de la grandeur dépendant de cette différence de potentiel minimale de la grandeur de référence dépendant de la vitesse de rotation (Vref) est déterminé et une erreur de réseau est détectée dans le cas où cet écart est supérieur à une valeur seuil prédéterminée, dans lequel en fonction des différences de potentiel et/ou de l'au moins un écart une erreur de réseau biphasée ou une erreur de réseau triphasée est déterminée.

2. Procédé selon la revendication 1, **caractérisé en ce que** lors de la détection d'une erreur de réseau, une vitesse de rotation (d) de la machine à aimants permanents (M) est réduite et/ou une autre interruption de la partie côté machine de la ligne de phase (P1, P2, P3) est réalisée.

3. Procédé selon l'une quelconque des revendications précédentes, **caractérisé en ce qu'**une précision de la détermination de la différence de potentiel est vérifiée en déterminant au moins une différence de potentiel en fonctionnement normal pour une ligne de phase ininterrompue (P1, P2, P3), dans lequel un écart de la différence de potentiel en fonctionnement normal d'une valeur de référence de fonctionnement normal est déterminé, dans lequel une précision suffisante est détectée dans le cas où l'écart est inférieur ou égal à une valeur seuil prédéterminée, et/ou **en ce qu'**un arrêt de la machine à aimants permanents (M) est détecté, dans lequel en cas de ligne de phase interrompue (P1, P2, P3) au moins une différence de potentiel d'arrêt est détectée, dans lequel un écart de la différence de potentiel d'arrêt d'une valeur de référence d'arrêt est déterminé, dans lequel une précision suffisante est détectée dans le cas où l'écart est inférieur ou égal à une valeur seuil prédéterminée.

4. Procédé selon l'une quelconque des revendications précédentes, **caractérisé en ce que** la vitesse de rotation (d) est attribuée à un intervalle de vitesse de rotation de plusieurs intervalles de vitesse de rotation, dans lequel une grandeur de référence dépendant de l'intervalle est attribuée à un intervalle de vitesse de rotation, dans lequel la grandeur de référence dépendant de la vitesse de rotation (Vref) est déterminée en tant que grandeur de référence dépendant de l'intervalle.

5. Procédé selon l'une quelconque des revendications précédentes, **caractérisé en ce que** la différence de potentiel est attribuée à un intervalle de différence de potentiel de plusieurs intervalles de différence de potentiel, dans lequel une valeur de différence de potentiel dépendant de l'intervalle est attribuée à un intervalle de différence de potentiel, dans lequel la grandeur dépendant de la différence de potentiel est déterminée en fonction de la valeur de différence de potentiel dépendant de l'intervalle.

6. Procédé selon l'une quelconque des revendications précédentes, **caractérisé en ce que** pour chaque ligne de phase (P1, P2, P3) une différence de potentiel entre une partie côté machine de la ligne de phase (P1, P2, P3) et un potentiel de référence et une grandeur dépendant de la différence de potentiel sont déterminées, dans lequel un signal de sortie combiné est formé, dans lequel le signal de sortie combiné comporte une première suite de bits qui code la grandeur dépendant de la différence de potentiel formée à partir de la différence de potentiel minimale, dans lequel le signal de sortie combiné comporte une autre suite de bits qui code une égalité de toutes les différences de potentiel.

7. Procédé selon l'une quelconque des revendications précédentes, **caractérisé en ce que** la grandeur dépendant de la différence de potentiel est une amplitude maximale ou une valeur RMS de la différence de potentiel pendant une période de détermination prédéterminée.

8. Dispositif de surveillance d'un réseau électrique (1) dans un véhicule ferroviaire, dans lequel le réseau électrique (1) comporte trois lignes de phase (P1, P2, P3), au moins un convertisseur (C), au moins une machine à aimants permanents (M) et au moins une première ligne de phase (P1) pour la liaison électrique de l'au moins un convertisseur (C) et de l'au moins une machine à aimants permanents (M) et au moins un dispositif d'interruption (S1_P1, S1_P2, S1_P3 ; S2_P1, S2_P2, S2_P3), dans lequel au moyen du dispositif d'interruption la première ligne de phase (P1) peut être interrompue, **caractérisé en ce que**
le dispositif comporte au moins un dispositif d'évaluation (AE) et au moins un dispositif de détermination (BE), dans lequel au moyen du dispositif de détermination (BE) une différence de potentiel entre une partie côté machine de la première ligne de phase (P1) et un potentiel de référence peut être déterminée, dans lequel en outre une grandeur dépendant de la différence de potentiel peut être déterminée, dans lequel une vitesse de rotation (d) de la machine à aimants permanents (M) et en fonction de la vitesse de rotation (d) une grandeur de référence dépendant de la vitesse de rotation (Vref) peuvent être déterminées, dans lequel un écart de la grandeur dépendant de la différence de potentiel de la grandeur de référence dépendant de la vitesse de rotation (Vref) peut être déterminé au moyen du dispositif d'évaluation (AE), dans lequel une erreur de réseau peut être détectée dans le cas où l'écart est supérieur à une valeur seuil prédéterminée, dans lequel au moins deux ou toutes les lignes de phase (P1, P2, P3) peuvent être interrompues, dans lequel pour chaque ligne de phase (P1, P2, P3) une différence de potentiel entre une partie côté machine de la ligne de phase (P1, P2, P3) et un potentiel de référence peut être déterminée, dans lequel une vitesse de rotation (d) de la machine à aimants permanents (M) et en fonction de la vitesse de rotation (d) une grandeur de référence dépendant de la vitesse de rotation (Vref) pour chaque ligne de phase (P1, P2, P3) peuvent être déterminées, dans lequel pour chaque ligne de phase (P1, P2, P3) une grandeur dépendant de la différence de potentiel et un écart de la grandeur dépendant de la différence de potentiel de la grandeur de référence dépendant de la vitesse de rotation (Vref) peuvent être déterminés et une erreur de réseau peut être détectée dans le cas où au moins un des écarts est supérieur à une valeur seuil prédéterminée et/ou dans lequel une différence de potentiel minimale de toutes les différences de potentiel et une grandeur dépendant de cette différence de potentiel minimale peuvent être déterminées, dans lequel un écart de la grandeur dépendant de cette différence de potentiel minimale de la grandeur de référence dépendant de la vitesse de rotation (Vref) peut être déterminé et une erreur de réseau peut être détectée dans le cas où cet écart est supérieur à une valeur seuil prédéterminée, dans lequel en fonction des différences de potentiel et/ou de l'au moins un écart une erreur de réseau biphasée ou une erreur de réseau triphasée peut être déterminée.

9. Dispositif selon la revendication 8, **caractérisé en ce que** la différence de potentiel est déterminée près du moteur.

10. Véhicule ferroviaire comprenant un dispositif selon l'une quelconque des revendications 8 ou 9.
